# EUROPEAN PATENT APPLICATION

(11) **EP 2 975 918 A1**
(43) Date of publication of application: **20.01.2016**
(21) Application number: 14177697.1
(22) Date of filing: 18.07.2014
(51) Int. Cl.: H05K 7/14

(54) **Sub-module removal method**

(71) Applicant: ALSTOM Technology Ltd, 5400 Baden (CH)
(72) Inventor: Jones, Philip, Stafford Staffordshire ST16 3XJ (GB); Habeb, Rawaa, Stafford ST17 4QF (GB); Evans, Michael, Stafford ST16 3JL (GB); Calgotra, Sarb, Penn Wolverhampton WV4 4AY (GB); Craik, kelvin, Congleton Cheshire CW12 4AS (GB); Mellor, Andrew, Stoke on Trent Staffordshire ST6 8GB (GB); Spibey, Neil, Rowley Park Stafford ST17 9AP (GB)
(74) Representative: McCartney, Jonathan William

(57) **Abstract**

There is disclosed a method of removing a sub-module 14 of a voltage source converter from a valve module frame 12. The method comprises coupling a lifting line 24 of an overhead lifting mechanism 18, such as a gantry crane, to the sub-module 12; sliding the sub-module 14 out of the frame 12 on a bearing 46, 52, 66, 74, disposed between the sub-module 14 and the frame 12; and moving the sub-module 14 to a resting location out of the frame 12 using the overhead lifting mechanism 18. There is also disclosed an apparatus for removing a sub-module 14 of a voltage source converter.

## Description

The invention relates to a method of removing a sub-module of a voltage source converter (VSC) from a valve module frame. In particular, although not exclusively, the invention relates to a method of removing a sub-module of a high-voltage direct current (HVDC) VSC from a valve module frame.

HVDC (high-voltage direct current) electrical power transmission uses direct current for the transmission of electrical power. This is an alternative to alternating current electrical power transmission which is more common. There are a number of benefits to using HVDC electrical power transmission.

In order to use HVDC electrical power transmission, it is necessary to convert alternating current (AC) to direct current (DC) and back again. Historically this has been done by using mercury arc valves which are sometimes known as line-commutated converters (LCC).

However, recent developments in the power electronics field has led to an increased use of voltages-source converters (VSC) for AC-DC and DC-AC conversion. Voltage source converters typically comprise six valves, each comprising a number of valve modules. Each valve module comprises a number of sub-modules mounted in a valve module frame or rack. In one example, each valve may comprise 48 valve modules, each containing eight sub-modules. In one valve, all of the sub-modules are connected in series. Each sub-module typically comprises a switching device, such as one or more insulated gate bipolar transistors, a capacitor and control and monitoring circuitry.

It may be necessary to remove (or insert valve) a sub-module from (or into) a valve module frame. For example, if a particular sub-module is broken or not functioning correctly it may be necessary to remove it from the valve module and replace it with a new (or a fixed) sub-module.

It is known to use a very narrow aisle (VNA) truck to remove a sub-module from a valve module frame. Whilst this may be satisfactory, in order to use a VNA truck the floor of the installation must be level and must be sufficiently strong to support the weight of the truck. For example, it may be necessary for the floor to be capable of supporting a 7 tonne point load. In an offshore HVDC VSC installation it may be difficult or expensive to provide a floor having sufficient strength. Further, in order to use a VNA truck it is necessary to leave sufficient space for the truck to be manoeuvred between the valve and the valve modules. This may unnecessarily increase the size and therefore cost of the installation.

It is therefore desirable to provide an improved method of removing a sub-module of a voltage source converter from a valve module frame.

According to an aspect there is provided a method of removing a sub-module of a voltage source converter from a valve module frame, the method comprising: coupling a lifting line of an overhead lifting mechanism to the sub-module; sliding the sub-module out of the frame on a bearing disposed between the sub-module and the frame; and moving the sub-module to a resting location out of the frame using the overhead lifting mechanism. The sub-module may be part of a valve module of a high-voltage direct current (HVDC) voltage source converter. The lifting line may be a cable, a chain, a rope or any other suitable lifting medium. The overhead lifting mechanism may comprise a hoist. The overhead lifting mechanism may be electrically operated. The overhead lifting mechanism may be positioned in front of the valve module frame. The bearing may be attached to the frame or attached to the sub-module. The sub-module may be horizontally slid out of the front of the frame. The lifting line may be directly attached to the sub-module or may be indirectly attached to the sub-module. The bearing may comprise bearing elements or a bearing surface, for example.

The method may further comprise inserting a bearing between the frame and the sub-module. The sub-module may be slid out of the frame over the bearing. The method may further comprise lifting at least a part of the sub-module away from the frame prior to inserting the bearing, and lowering the sub-module onto the bearing following insertion. Lifting the sub-module may comprise lifting the entire sub-module away from the frame or it may comprise tipping or pivoting the sub-module. At least a part of the sub-module may be lifted away from the frame prior to inserting the bearing, and may be subsequently lowered onto the bearing following insertion using the overhead lifting mechanism.

The method may further comprise locating a lifting platform (such as a plate, fork or tine) under at least a part of the sub-module, lifting the lifting platform to lift at least a part of the sub-module away from the frame, and lowering the lifting platform the lower the sub-module onto the bearing. The lifting platform may be lifted and subsequently lowered using an overhead lifting mechanism. Lifting the lifting platform may comprise lifting an end of the lifting platform, thereby causing it to tip the sub-module. The lifting platform may be a plate or a series of prongs or bars. The lifting platform may be secured to the sub-module prior to lifting it. When located under the sub-module, the lifting platform may extend beyond the front of the valve module frame and the overhead lifting mechanism may be aligned directly above a part of it.

The method may further comprise withdrawing the lifting platform from under the sub-module prior to sliding the sub-module out of the frame.

The bearing may be secured to the frame following insertion. This may be achieved by fixings or fittings provided on the bearing, or separate fixing or fittings may be used to secure the bearing in place.

The bearing may be inserted such that a bearing platform portion extends beyond the front of the frame. The bearing platform portion may be aligned with the overhead lifting mechanism. The sub-module may be slid out of the frame onto the bearing platform portion, and it may lie directly underneath the overhead lifting mechanism. The sub-module may be lifted away from the bearing platform portion using the overhead lifting mechanism. The sub-module may be lifted directly vertically upwards.

The bearing may comprise a bearing bed having a plurality of bearing elements. The bearing bed may be substantially rectangular, for example. The bearing elements may be roller bearings, ball bearings or any other suitable element.

The bearing bed may further comprise a bearing frame. The bearing elements may be moveable between at least a lowered position and a raised position with respect to the bearing frame. The bearing elements may be in the lowered position when the bearing is inserted between the frame and the sub-module. The bearing elements may be subsequently moved to the raised position such that they bear against the sub-module and lift it away from the frame. In the raised position the bearing elements may project above the general level of the bearing frame, whilst in the lowered position the bearing elements may lie below the general level of the bearing frame.

The bearing may comprise a plurality of bearing elements provided on the sub-module. The bearing elements may be roller bearings or wheels or the like.

The bearing may comprises a bearing plate which is part of a lifting frame attached to the lifting line. The method may comprise inserting the bearing plate under at least a part of the sub-module such that the lifting line is coupled to the sub-module, sliding the sub-module out of the frame over and onto the bearing plate, and moving the lifting frame using the overhead lifting mechanism to move the sub-module to the resting location. The bearing plate may have a low friction surface along which the sub-module can easily slide.

Coupling the lifting line to the sub-module may comprise coupling the lifting line to at least one lifting point provided on the sub-module. The lifting line may be coupled to a lifting point using a shackle or the like. The method may further comprise raising the lifting line to slide the sub-module out of the frame. The lifting line may pass over a guide, such as a guide roller, attached to the frame. The method may further comprise coupling an adjustable levelling mechanism to at least two lifting points provided on the sub-module. The levelling mechanism may be attached to the lifting line. The method may further comprise adjusting the levelling mechanism whilst raising the lifting line so that the sub-module is kept substantially horizontal as it is slid out of the frame.

Moving the sub-module to a resting location may comprise raising the lifting line to lift the sub-module and/or lowering the lifting line to lower the sub-module and/or rotating the sub-module. The resting location may be the floor of the installation or another platform, for example.

The overhead lifting mechanism may comprise an overhead gantry crane. The overhead gantry may comprise a trolley which can move horizontally over a guide rail in a direction parallel to the front face of the valve module frame. The guide rail may be located in front of the face of the valve module frame.

It should be appreciated that the method steps may be carried out in any order and the order in which they are presented is not limiting.

According to another aspect there is provided an apparatus for removing a sub-module of a voltage source converter from a valve module frame, the apparatus comprising: an overhead lifting mechanism having a lifting line which can be coupled to the sub-module; and a bearing which is, or which can be, disposed between the sub-module and the frame, wherein the sub-module can be slid out of the frame on the bearing; wherein in use, once the sub-module has been slid out of the frame on the bearing, the overhead lifting mechanism can be operated to move the sub-module to a resting location out of the frame. The apparatus may comprise a bearing bed and/or a lifting platform and/or a lifting frame and/or an adjustable levelling mechanism.

The invention may comprise any combination of the features and/or limitations referred to herein, except combinations of such features as are mutually exclusive.

Embodiments of the invention will now be described, by way of example, with reference to the accompanying drawings, in which:
Figure 1 schematically shows a side view of a HVDC voltage-source converter installation including an overhead gantry crane and a number of valve modules mounted on top of one another;
Figure 2 schematically shows a front view of a single sub-module secured within a valve module rack;
Figures 3-7 and 8-11 schematically illustrate a sub-module removal process;
Figure 6 schematically shows a top view of a bearing bed;
Figure 12 schematically shows a perspective view of an alternative bearing bed;
Figure 13 schematically shows a front view of a single sub-module within a valve module rack with the bearing bed of Figure 12 located between the sub-module and the rack;
Figure 14 schematically shows a front view of a single sub-module within a valve module rack with the bearing bed of Figure 12 located between the sub-module and the rack, and with the bearing plate in a raised position;
Figure 15 schematically illustrates a further sub-module removal process;
Figure 16 schematically shows a front view of a single sub-module secured within a valve module rack with bearings provided on the underside of the sub-module; and
Figures 17-21 schematically illustrate yet a further sub-module removal process.

In an HVDC voltage source converter (VSC) sub-station which converts AC to DC or vice versa, there are typically six valves, each constructed from a number of valve modules, with each valve module containing a number of sub-modules electrically connected in series. Each valve module is in the form of a frame or rack containing a number of, such as eight, sub-modules located side-by-side. Each sub-module typically comprises a switching device, such as one or more insulated gate bipolar transistors, a capacitor and control and monitoring circuitry. In one example, each valve comprises 48 valve modules, resulting in a 384 sub-modules which are connected in series.

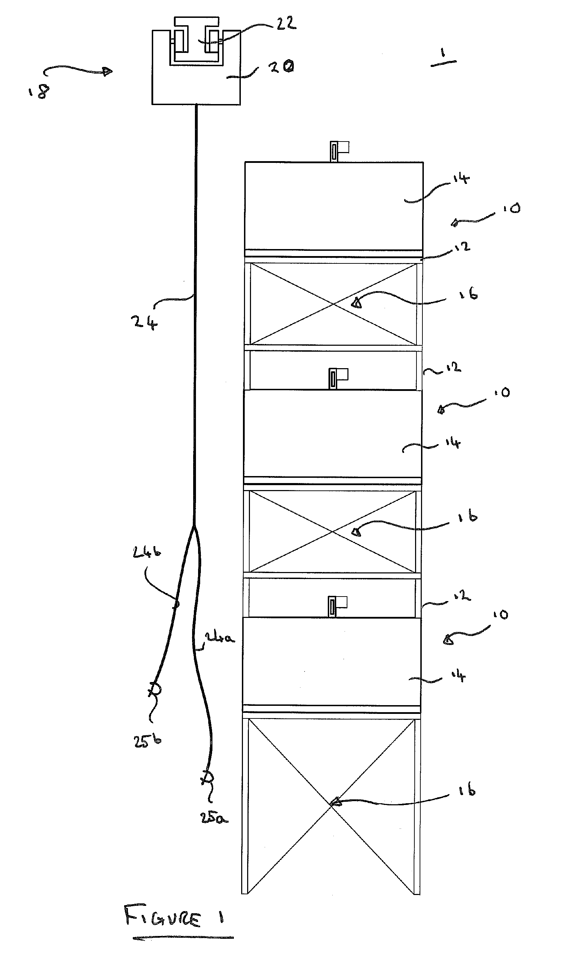

**Figure 1** shows part of a valve of a HVDC voltage-source converter (VSC) installation 1 comprising three valve modules 10 stacked on top of one another. Each valve module 10 comprises a frame (or rack) 12 within which eight sub-modules 14 are located side-by-side. The valve modules 10 are separated by insulation assemblies 16 which are attached to the frames 12. The installation 1 is also provided with an overhead lifting mechanism in the form of an overhead gantry crane 18. The gantry crane 18 comprises a crane trolley 20 that can move horizontally side-to-side along a guide rail 22 which is positioned in front of the valve modules. The crane trolley 20 is provided with a hoist (not shown) having a main lifting line in the form of a main cable 24. The main cable 24 hangs vertically downwards and the gantry crane 18 is positioned such that the cable 24 hangs across the front of the valve modules 10. In this embodiment the main cable 24 is provided with two sub-cables 24a, 24b, each provided with an attachment shackle 25a, 25b. The crane 18 can be operated to raise and lower the cable 24.

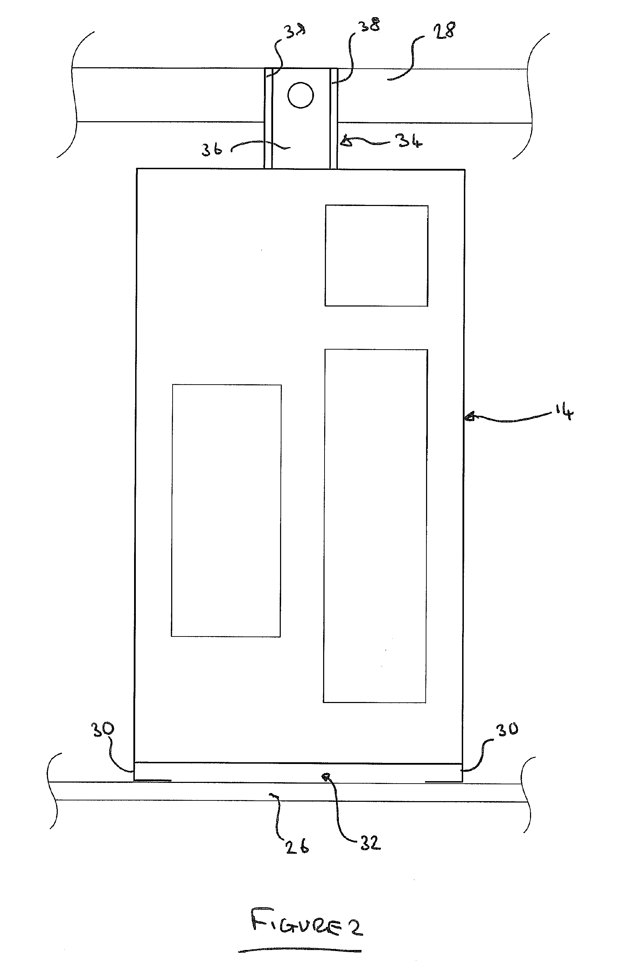

Referring to **Figure 2****,** the valve module frame 12 is formed from a number of support bars including lower horizontal support bars 26 which form a base for the sub-modules 14 to sit on, and an attachment bar 28 to which the sub-modules 14 can be secured. Each sub-module 14 is substantially cuboidal in shape and two L-shaped rails 30 are attached to the lower surface of the sub-module 14. The rails 30 are attached at opposing sides of the sub-module 14 and extend from the front to the rear of the sub-module 14. The rails 30 rest on the horizontal support bars 26 of the valve module frame 12. The rails 30 define a cavity (or slot) 32 underneath the main body of the sub-module 14 (i.e. between the rails 30 of the frame 12 and the sub-module 14). The sub-module 14 is also provided with a lifting point 34 having a main bracket 36 with a hole formed therein, and two side flanges 38. The lifting point 34 is provided at a position above the centre of gravity of the sub-module 14. With the sub-module 14 mounted in the frame 12, the bracket 36 abuts the attachment bar 28 and is bolted thereto using an upper bolt which passes through the hole into the attachment bar 28. A second lower bolt (not shown) is also used to bolt a lower part of the sub-module 14 to the frame 12. This arrangement secures the sub-module 14 within the frame 12.

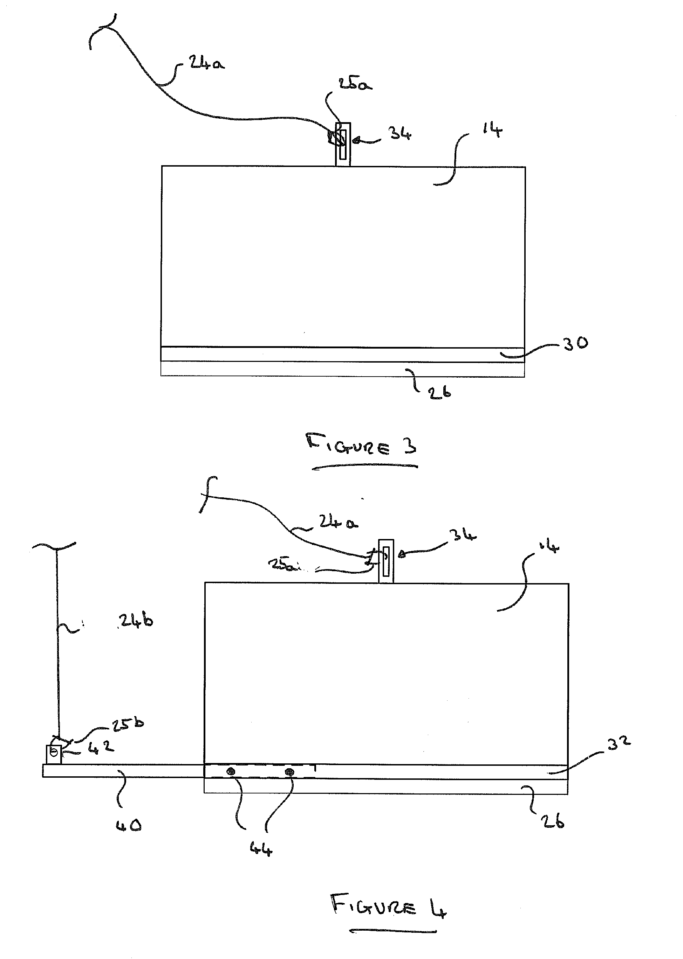

It may be desirable to remove a sub-module 14 from the valve module frame 12 for maintenance purposes or the like. There will now be described a method of removing a sub-module 14:
With reference to **Figures 3****,** the upper and lower bolts are removed so that the sub-module 14 is no longer secured to the frame 12. The attachment shackle 25a of one of the sub-cables 24a is then secured to the lifting point 34 by locating it in slots provided in the flanges 38. As shown in **Figure 4****,** a lifting platform 40 is then inserted into the cavity 32 underneath the sub-module 14 which is defined by the height of the rails 30. The lifting platform 40 is a rectangular plate having a width substantially the same as the internal distance between the rails 30, and has a height substantially the same as the internal height of the rails 30 (i.e. the distance between the horizontal support bars 26 and the underside of the sub-module 14). The lifting platform 40 is provided with a lifting eyelet 42 at one end, and the attachment shackle 25b of the other sub-cable 24b is secured to this eyelet 42. The lifting platform 40 is inserted into the cavity 32 underneath the sub-module 14 so that one end of the lifting platform 40 extends beyond the front of the valve module frame 12. The lifting platform 40 is provided with a stop (not shown) to limit the insertion into the cavity 32. When the lifting platform 40 has been correctly inserted, fixings 44 are passed through the rails 30 into the lifting platform 40 to secure the lifting platform 40 to the sub-module 14.

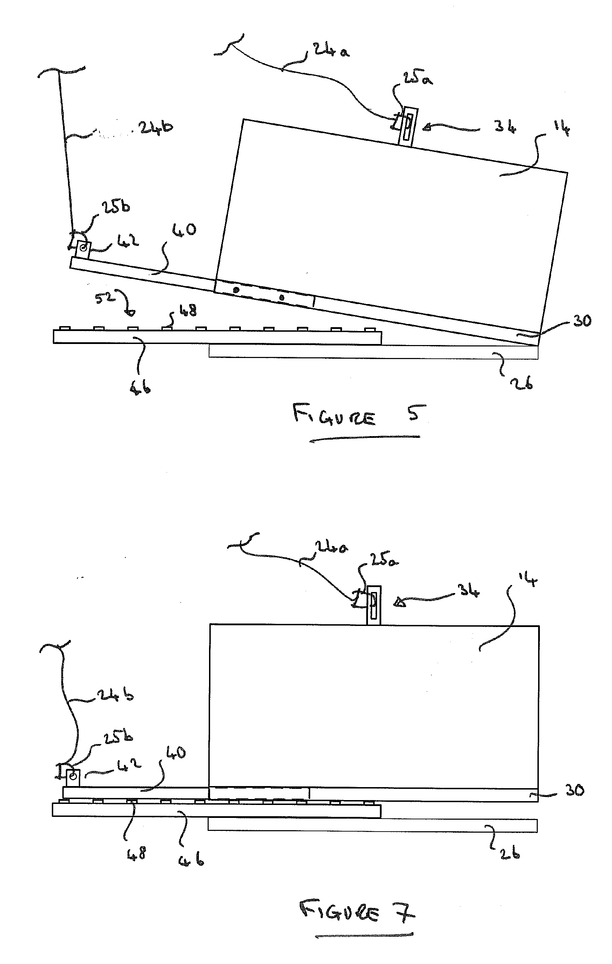

Referring to **Figure 5****,** the gantry crane 18 is then operated to raise the cable 24, thereby causing the sub-module 14 to be pivoted at its rear so that it is lifted away from the frame 14, in particular away from the horizontal support bars 26. The sub-module 14 is lifted using the lifting platform 40, rather than by lifting the sub-module itself, since the sub-cable 24a attached to the sub-module 14 lifting point 34 is longer than the sub-cable 25b attached to the lifting platform 40 lifting eyelet 42. The sub-module 14 is lifted by pivoting until it is a sufficient distance away from the support bars 26 that a bearing bed 46 can be located underneath it.

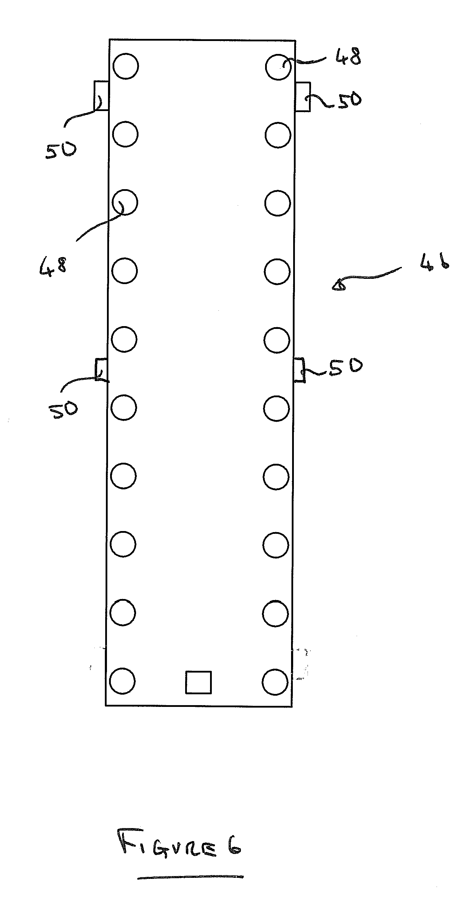

As shown in **Figure 6****,** the bearing bed 46 is substantially rectangular and comprises two sets of bearing elements 48 in the form or roller bearings or the like. The bearing bed 46 is of substantially the same width as that of the sub-module 14. The bearing elements 48 are arranged in two parallel lines extending front to back and are arranged to be aligned with the rails 30 of the sub-module 14. The bearing bed 46 is also provided with four fixings 50 that can be used to secure the bearing bed 46 to the valve module frame 12. Referring back to Figure 5, with the sub-module 14 pivoted away from the frame 12, the bearing bed 46 is inserted underneath it such that extends beyond the front of the frame 12 to provide a bearing platform portion 52. The bearing bed 46 is then secured to the frame 12 using the fixings 50.

Referring now to **Figure 7****,** after the bearing bed 46 has been inserted and fixed to the frame 12 the gantry crane 18 is operated to lower the cable 24. This causes the lifting platform 40 to be lowered, which in turn causes the sub-module 14 to be lowered such that it sits on the bearing bed 46. Since the centre of gravity of the sub-module 14 is over the bearing bed 46, the sub-module 14 is supported on the bearing bed 46 such that it is substantially horizontal. With the sub-module 14 supported on the bearing bed 46, the underside of the L-shaped rails 30 are aligned with and rest on the bearing elements 48.

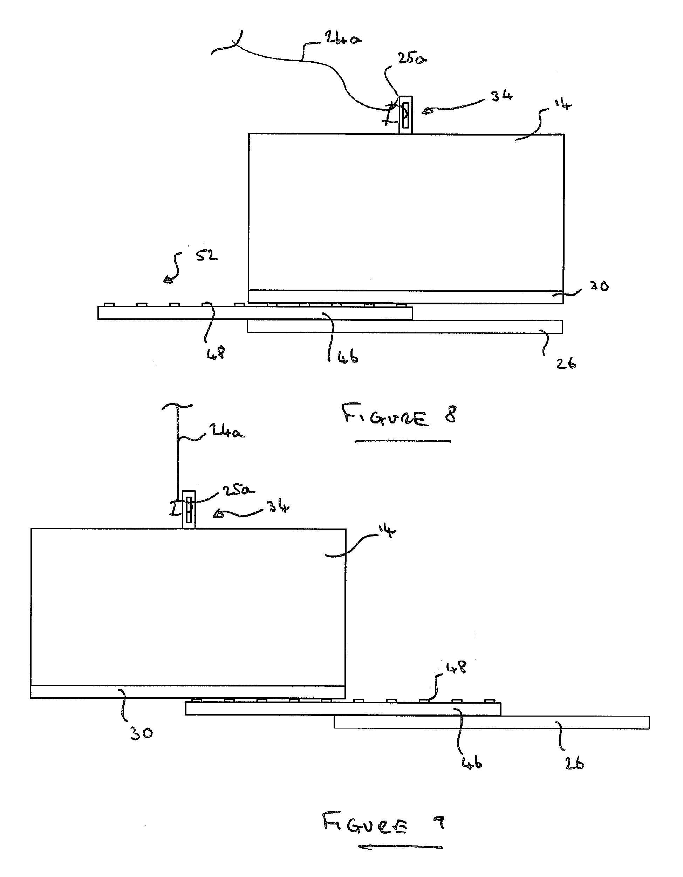

As shown in **Figure 8****,** after the sub-module 14 has been lowered onto the bearing bed 46, the lifting platform 40 is removed from underneath the sub-module 14. As shown in **Figure 9****,** the sub-module 14 is then slid forwards in a horizontal direction out of the frame 12 along the bearing bed 46 with the rails 30 sliding over the bearing elements 48. The sub-module 14 is slid into a withdrawn position in which the rear of the sub-module 14 sits on the bearing platform portion 52 of the bearing bed 46 (i.e. the part of the bearing bed 46 that projects beyond the front of the frame 12). Although not show, the bearing bed 46 is provided with stops that prevent the sub-module from being slid beyond this withdrawn position. In the withdrawn position, the centre of gravity of the sub-module 14 is aligned over the bearing bed 46 which prevents the sub-module 14 from tipping off the end of the bearing bed 46. Further, in this position the lifting point 34 of the sub-module 14 is vertically aligned with the gantry crane 18 and the vertical lifting line 24 and is located outside of the frame 12.

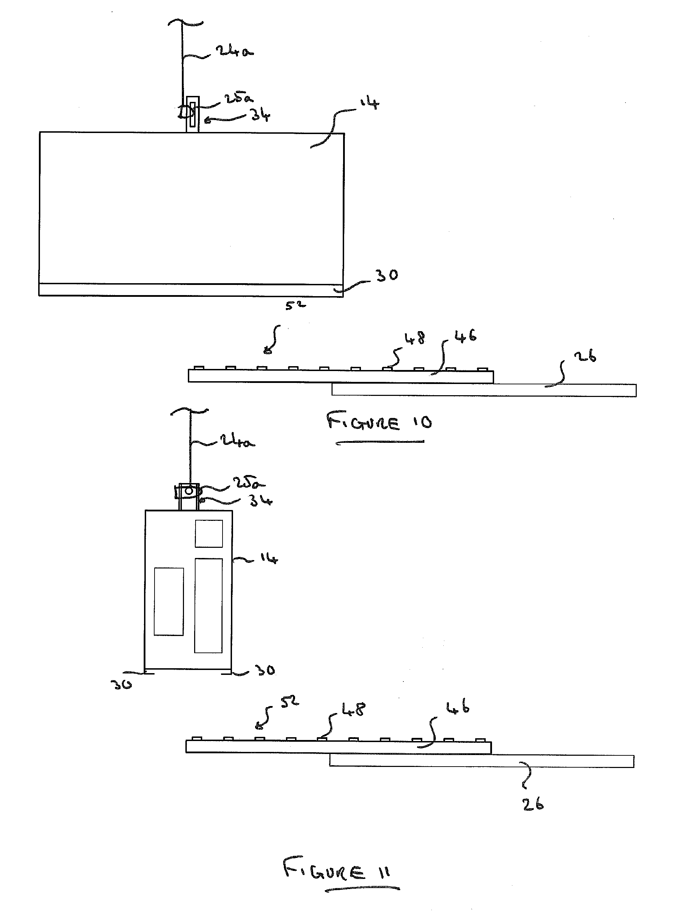

Referring to **Figure 10****,** the gantry crane 18 is then operated to vertically raise the cable 24 and hence the sub-cable 24a. This causes the sub-module 14 to be vertically lifted away from the bearing bed 46. Since the sub-module 14 is withdrawn from the frame 12, it does not collide with the frame 12 during the lift. As shown in **Figure 11****,** the sub-module 14 can then be rotated by 90° to move it further away from the front of the frame 12. The gantry crane 18 is then operated to move the removed sub-module 14 to a resting location, which may be the floor, for example. This may involve moving the sub-module 14 horizontally (by moving the crane trolley 20 along the overhead guide rail 22), lifting the sub-module 14 further, and/or lowering the sub-module 14. Following removal of a sub-module 14, the bearing bed 46 can either be removed, or it can be left in place in order to assist in the installation of another sub-module 14. The process for installing a sub-module 14 is the reverse of the process for removing a sub-module 14.

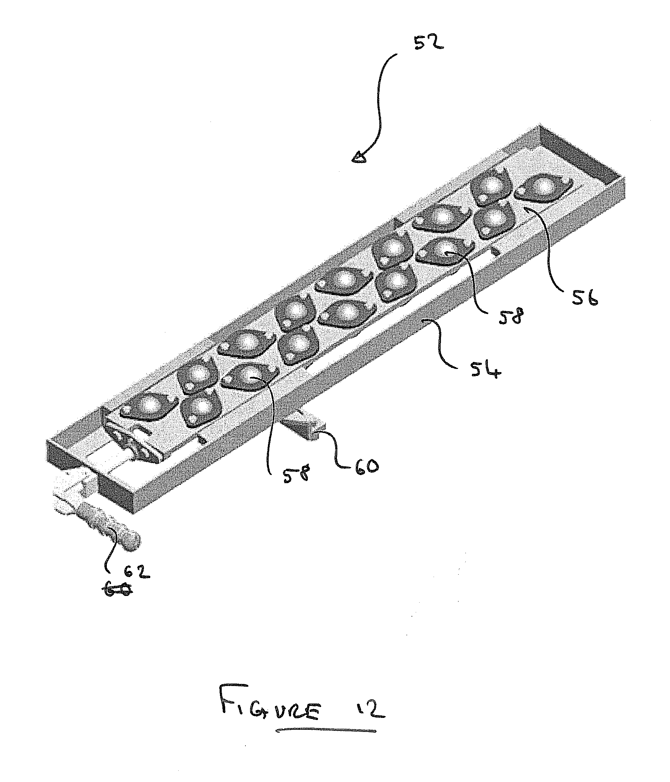

**Figure 12** shows an alternative bearing bed 52 that may be used in a sub-module removal process. The bearing bed 52 is generally rectangular and comprises a rectangular frame 54 and a bearing plate 56 disposed within the frame and to which is mounted a plurality of bearing elements 58. The bearing bed frame 54 has a thickness slightly less than the gap between the horizontal support bars 26 and the underside of the sub-module 14, and has a width less than the width between the L-shaped rails 30. The bearing frame 54 is provided with fixings 60 that allows it to be secured to the valve module frame 12. The bearing plate 56 can be raised and lowered within the rectangular frame 54 in a direction perpendicular to the general plane of the bearing bed 52. Specifically, the bearing plate 56 can be moved between a lowered position in which the bearing elements 58 are below the top of the frame 54, and a raised position in which they project above the general level of the frame 54. A lever 62 is provided which can be used to raise and lower the bearing plate 56.

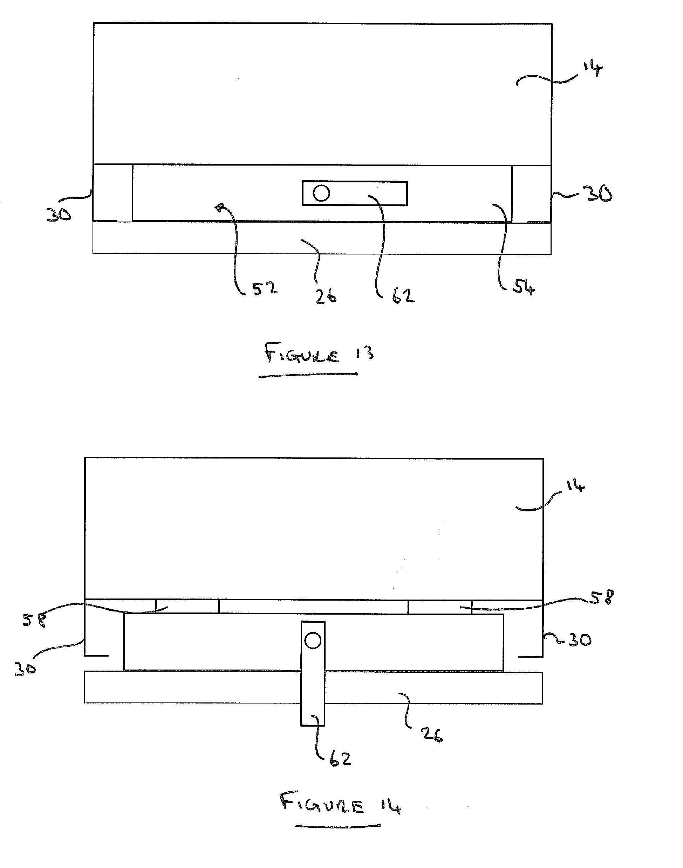

The bearing bed 52 can be used in a sub-module removal process that is somewhat similar to that described above with reference to Figures 3-11. However, it is not necessary to lift/pivot the sub-module 14 away from the valve module frame 12 before inserting the bearing bed 52. As shown in **Figure 13****,** with the bearing plate 56 in the lowered position, the bearing bed 52 is inserted into the cavity 32 between the sub-module 14 and the horizontal support bars 26 such that it is between the rails 30. The bearing bed 54 is then secured to the valve module frame 12 using the fixings 60 provided. Referring to **Figure 14****,** the lever 62 is then rotated, which causes the bearing plate 56 to rise towards the underside of the sub-module 14 with respect to the frame 54. The bearing elements 58 thus come into contact with the underside of the sub-module 14 and, with the lever 62 fully rotated, lift it away from the support bars 26. The sub-module 14 is then slid horizontally out of the frame 12 over the bearing bed 52. As for the process described above, the gantry crane 18 is then operated to move the sub-module 14 to an appropriate resting location.

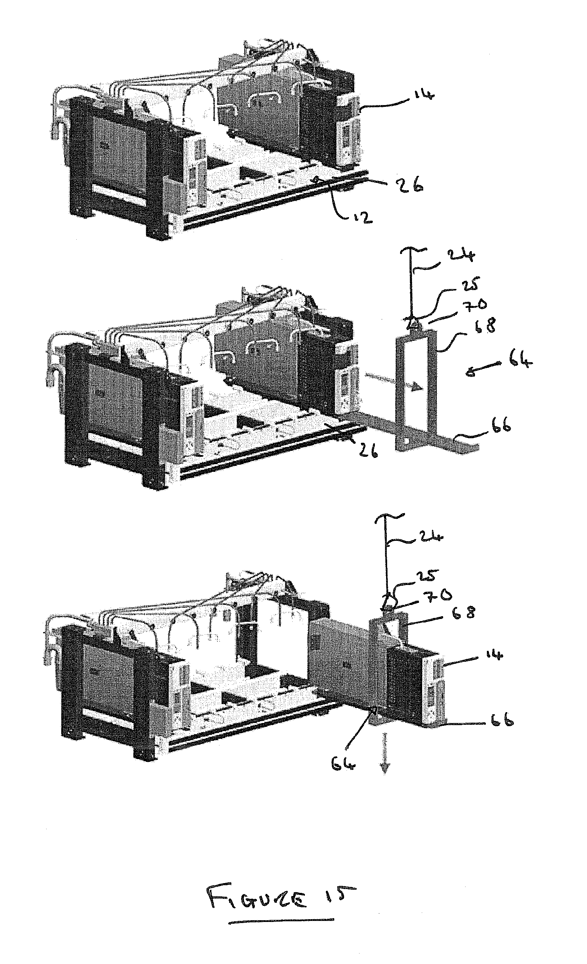

**Figure 15** illustrates a further process for removing a sub-module 14 from a valve module frame 12 using an overhead gantry crane 18. In this embodiment, a lifting frame 64 is provided which comprises an elongate bearing plate 66 having bearing surface and a rectangular cradle member 68. The cradle member 68 is in the form of a rectangular frame having an opening larger than the rectangular cross section of the sub-module 14. The cradle member 68 is attached to the bearing plate 66 at approximately the mid-point and the two are substantially perpendicular to one another. The cradle member 68 is provided with a lifting point 70 to which a shackle 25 attached to the lifting cable 24 is secured. In order to remove a sub-module 14, the tip of the bearing plate 66 is inserted into the cavity 32 between the sub-module 14 and the support bars 26 of the frame 12. The sub-module 14 is then slid horizontally forwards onto the bearing plate 66. The bearing plate 66 may be a low-friction surface or may be provided with bearing elements such as roller or ball bearings. When the sub-module 14 has been located onto the lifting frame 64, the overhead gantry crane 18 can be operated to move the sub-module 14 to the desired location. This may involve moving the lifting frame 64 horizontally (by moving the crane trolley 20 along the overhead guide rail 22), lifting the lifting frame 64, and/or lowering the lifting frame 64.

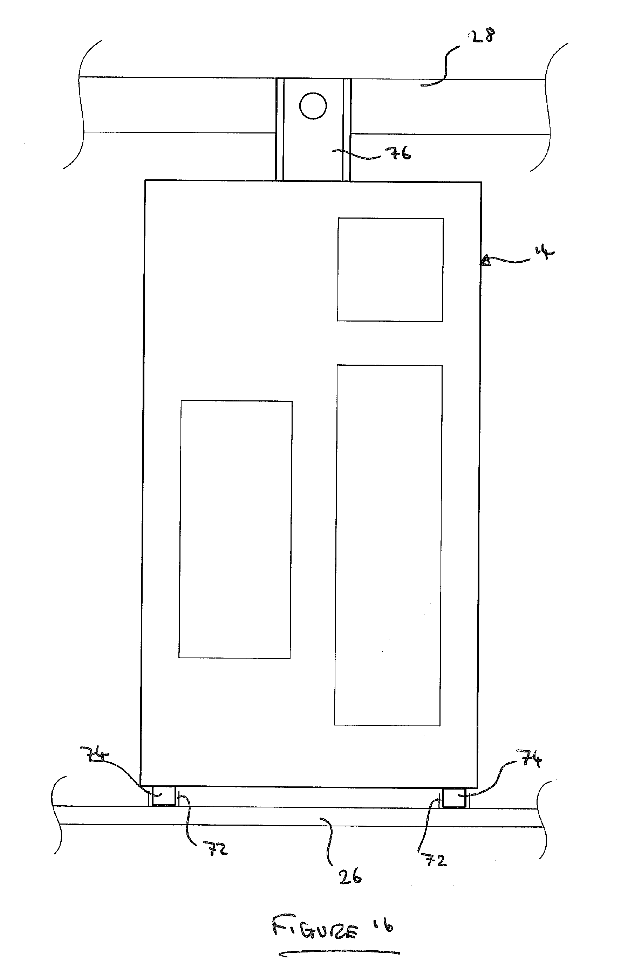

**Figure 16** shows a sub-module 14 secured within a valve module frame 12 in a similar manner to that shown in Figure 2. However, in this embodiment two elongate U-shaped rails 72 are attached to the horizontal support bars 26 and extend from the front to the rear of the frame 12. The underside of the sub-module 14 is provided with a plurality of bearings 74 arranged in two spaced apart lines that extend from the front to the rear of the sub-module 14. The bearings 74 provided on the underside of the sub-module 14 are located in the U-shaped rails 72 fixed to the frame 12. Further, as described below, the sub-module 14 is provided with two lifting points 76, 78 that are spaced from one another (front to back).

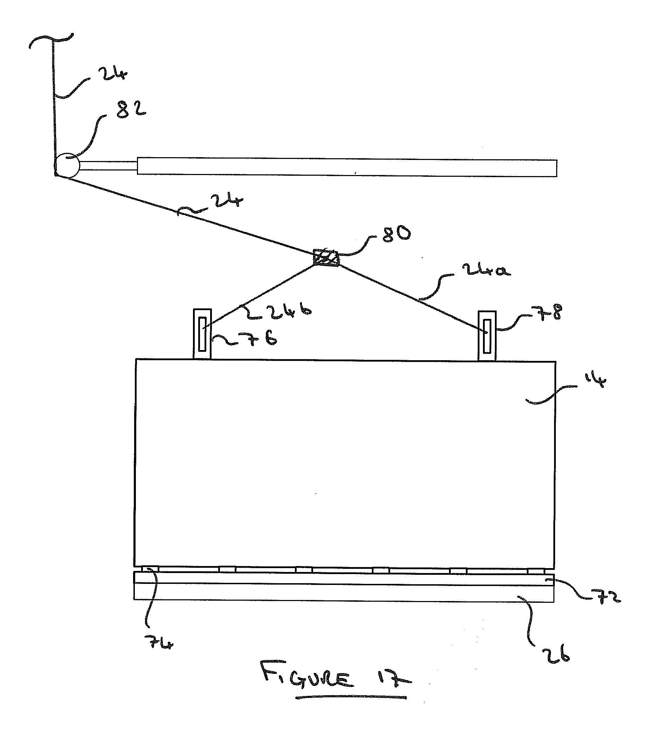

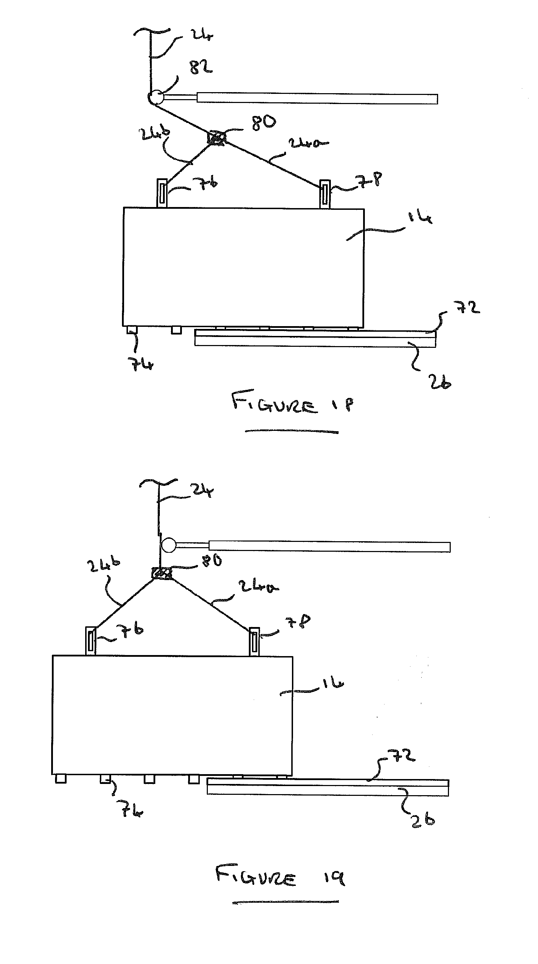

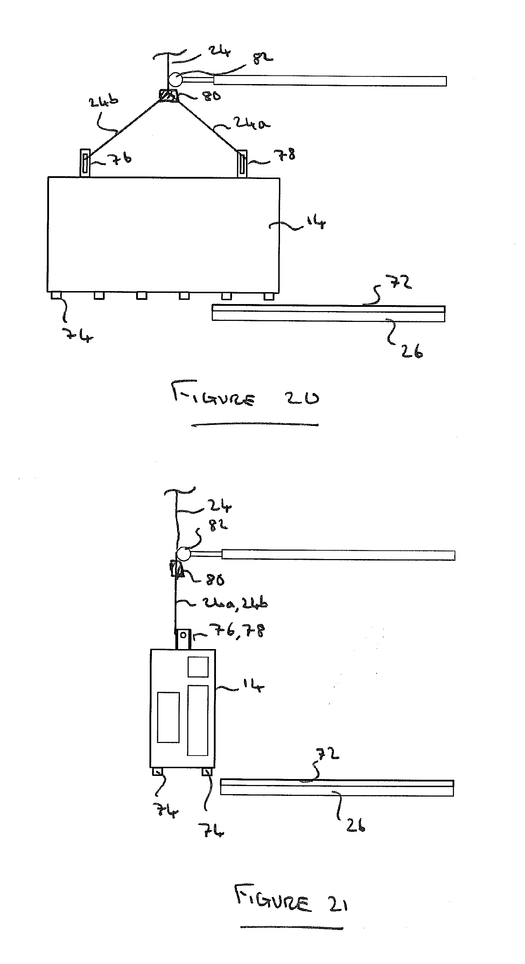

As shown in **Figure 17****,** in order to remove a sub-module 14 a first sub-cable 24a is attached to the rear lifting point 78 and a second sub-cable 24b is attached to the front lifting point 76. The sub-cables are attached to the main cable 24 and an adjustable levelling device 80 is provided which allows the lengths of the two sub-cables to be altered. A guide roller 82 is attached to a fixed point (such as part of the valve module frame 12) at a position aligned with the vertical line of the main cable 24 and the main cable 24 runs over this guide roller 82. This prevents the main cable 24 from coming into contact with the valve modules 10. The overhead gantry crane 18 is then operated to vertically raise the main cable 24. This causes the sub-module 14 to be slid forwards and horizontally out of the frame 12, with the bearings 74 running in the rails 72. As shown in **Figures 18 and 19****,** as the sub-module 14 is slid out of the front of the frame 12, the levelling device 80 is adjusted to change the lengths of the two sub-cables 24a, 24b. This keeps the sub-module 14 substantially horizontal. As shown in **Figure 20****,** when the sub-module 14 has been withdraw such that it directly underneath the guide roller 82 (and hence the vertical lifting line) further raising of the main cable 24 causes the sub-module the be vertically lifted away from the valve module frame 12. If necessary, the sub-module 14 can be rotated by 90° to keep it clear from the frame 12 **(****Figure 21****).** The overhead gantry crane 18 can then be used to move the sub-module 14 to an appropriate resting location. This may involve moving the sub-module 14 horizontally (by moving the crane trolley 20 along the overhead guide rail 22), lifting the sub-module 14 further, and/or lowering the sub-module 14.

The above described processes for removing a sub-module 14 from a valve module frame 12 all utilise an overhead lifting mechanism such as a gantry crane. The removal methods therefore avoid the use of a vehicle, such as a very narrow aisle truck (VNA), running on the floor of the installation. This may reduce the space required for the installation and may allow a floor of a reduced strength to be used. This may reduce the costs of the installation.

## Claims

1. A method of removing a sub-module of a voltage source converter from a valve module frame, the method comprising:
coupling a lifting line of an overhead lifting mechanism to the sub-module;
sliding the sub-module out of the frame on a bearing disposed between the sub-module and the frame; and
moving the sub-module to a resting location out of the frame using the overhead lifting mechanism.

2. A method according to claim 1, further comprising inserting a bearing between the frame and the sub-module, wherein the sub-module is slid out of the frame over the bearing.

3. A method according to claim 2, further comprising lifting at least a part of the sub-module away from the frame prior to inserting the bearing, and lowering the sub-module onto the bearing following insertion.

4. A method according to claim 3, wherein at least a part of the sub-module is lifted away from the frame prior to inserting the bearing and subsequently lowered onto the bearing following insertion using an overhead lifting mechanism.

5. A method according to claim 3 or 4, further comprising locating a lifting platform under at least a part of the sub-module, lifting the lifting platform to lift at least a part of the sub-module away from the frame, and lowering the lifting platform the lower the sub-module onto the bearing.

6. A method according to claim 5, wherein the lifting platform is lifted and subsequently lowered using an overhead lifting mechanism.

7. A method according to claim 5 or 6, further comprising withdrawing the lifting platform from under the sub-module prior to sliding the sub-module out of the frame.

8. A method according to any of claims 2-7, wherein the bearing is secured to the frame following insertion.

9. A method according to any of claims 2-8, wherein the bearing is inserted such that a bearing platform portion extends beyond the front of the frame.

10. A method according to claim 9, wherein the sub-module is slid out of the frame onto the bearing platform portion, and wherein the sub-module is lifted away from the bearing platform portion using the overhead lifting mechanism.

11. A method according to any of claims 2-10, wherein the bearing comprises a bearing bed having a plurality of bearing elements.

12. A method according to any preceding claim, wherein coupling the lifting line to the sub-module comprises coupling the lifting line to at least one lifting point provided on the sub-module.

13. A method according to any preceding claim, wherein moving the sub-module to a resting location comprises raising the lifting line to lift the sub-module and/or lowering the lifting line to lower the sub-module and/or rotating the sub-module.

14. A method according to any preceding claim, wherein the overhead lifting mechanism comprises an overhead gantry crane.

15. An apparatus for removing a sub-module of a voltage source converter from a valve module frame, the apparatus comprising:
an overhead lifting mechanism having a lifting line which can be coupled to the sub-module; and
a bearing which is, or which can be, disposed between the sub-module and the frame, wherein the sub-module can be slid out of the frame on the bearing;
wherein in use, once the sub-module has been slid out of the frame on the bearing, the overhead lifting mechanism can be operated to move the sub-module to a resting location out of the frame.
